# EUROPEAN PATENT APPLICATION

(11) **EP 4 692 939 A1**
(43) Date of publication of application: **11.02.2026**
(21) Application number: 24932606.7
(22) Date of filing: 17.10.2024
(51) Int. Cl.: G03F 7/039, G03F 7/26

(54) **METHOD FOR USING DEGRADABLE FILM AND METHOD FOR PRODUCING RESIST PATTERN**

(30) Priority: 26.03.2024 JP 2024050443
(71) Applicant: LINTEC CORPORATION, Itabashi-ku Tokyo 173-0001 (JP)
(72) Inventor: HAYASAKA Ryohei, Tokyo 173-0001 (JP); MORIOKA Takashi, Tokyo 173-0001 (JP); WATANABE Yasutaka, Tokyo 173-0001 (JP); AJINO Keiko, Tokyo 173-0001 (JP); GODA Hideki, Kobe-shi, Hyogo 651-0093 (JP)
(74) Representative: J A Kemp LLP
(86) International application number: PCT/JP2024/037077
(87) International publication number: WO 2025/203788

(57) **Abstract**

A method of using a decomposable film, comprising: a step of preparing a decomposable film containing an aliphatic polycarbonate and an acid/base generator that generates an acid or base by irradiation with energy rays, the decomposable film containing 10 mass% or less of a pressure sensitive adhesive resin other than the above aliphatic polycarbonate; an irradiation step of irradiating an entire surface of the above decomposable film or a part of the above decomposable film in a planar view with energy rays; and a decomposition step of heating the decomposable film to decompose the entire surface of the decomposable film or the part of the decomposable film in the planar view. According to the method of using a decomposable film, the decomposable film can be easily decomposed.

## Description

### Technical Field

The present invention relates to a method of using a decomposable film and a method of producing a resist pattern.

### Background Art

Photolithography has heretofore been used to form patterns on thin films and the like using light, and resists are used to form the patterns. There are negative and positive types of photolithography. In negative types, the parts exposed to light become the pattern, while in positive types, the parts not exposed to light become the pattern. When photolithography was first developed, negative types were mainstream, but nowadays positive types, which use highly sensitive resists, are mainstream.

As a positive type resist, for example, a chemically amplified positive type photosensitive composition has been proposed in Patent Document 1.

### Prior Art Documents

### Patent Documents

Patent Document 1 :JP2022-129980A

### Summary of the Invention

### Problems to be solved by the Invention

Conventional photoresists require a development step using a developer and pure water to form a pattern after exposure, but a dry process is desired to improve the work environment and prevent environmental pollution.

Objects of the present invention include providing a method of using a decomposable film that can easily decompose the decomposable film and providing a method of producing a resist pattern that can easily produce a resist pattern.

### Means for solving the Problems

To achieve the above objects, first, the present invention provides a method of using a decomposable film, comprising: a step of preparing a decomposable film containing an aliphatic polycarbonate and an acid/base generator that generates an acid or base by irradiation with energy rays, the decomposable film containing 10 mass% or less of a pressure sensitive adhesive resin other than the aliphatic polycarbonate; an irradiation step of irradiating an entire surface of the decomposable film or a part of the decomposable film in a planar view with energy rays; and a decomposition step of heating the decomposable film to decompose the entire surface of the decomposable film or the part of the decomposable film in the planar view (Invention 1).

Second, the present invention provides a method of using a decomposable film, comprising: a step of preparing a decomposable film containing an aliphatic polycarbonate and an acid/base generator that generates an acid or base by irradiation with energy rays; an irradiation step of irradiating an entire surface of the decomposable film or a part of the decomposable film in a planar view with energy rays; and a decomposition step of heating the decomposable film at 30°C or higher and 120°C or lower to decompose the entire surface of the decomposable film or the part of the decomposable film in the planar view (Invention 2).

In the above invention or inventions (Inventions 1 and 2), when the decomposable film is irradiated with energy rays, an acid or base is generated by the action of the acid/base generator. The action of this generated acid or base lowers the back-biting initiation temperature of the aliphatic polycarbonate, allowing it to decompose even at a relatively low temperature. By heating the decomposable film in this state, the aliphatic polycarbonate is effectively thermally decomposed, and the decomposable film itself is also decomposed. Thus, according to the above method of using a decomposable film, the decomposable film can be easily decomposed, and if desired, the decomposable film can be decomposed at a relatively low temperature.

In the above invention or inventions (Inventions 1 and 2), the energy rays used for irradiation in the irradiation step may preferably include energy rays with at least a part of wavelengths of 150 to 400 nm (Invention 3).

In the above invention or inventions (Inventions 1 to 3), the energy rays used for irradiation in the irradiation step may preferably have a light amount of 50 mJ/cm² or more and 1,500 mJ/cm² or less (Invention 4).

In the above invention or inventions (Inventions 1 to 4), the heating time in the decomposition step may be preferably 1 minute or more and 30 minutes or less (Invention 5).

In the above invention or inventions (Inventions 1 to 5), preferably, the acid/base generator may be an acid generator that generates an acid by irradiation with energy rays, and the acid generator may have a sulfonium salt structure and have a molar absorption coefficient of 50 M⁻¹cm⁻¹ or more for energy rays with a wavelength of 365 nm (Invention 6).

In the above invention or inventions (Inventions 1 to 5), preferably, the acid/base generator may be a base generator that generates a base by irradiation with energy rays, and the base generator may have a biguanide salt structure and haves a molar absorption coefficient of 50 M⁻¹cm⁻¹ or more for energy rays with a wavelength of 365 nm (Invention 7).

In the above invention or inventions (Inventions 1 to 7), the decomposable film may preferably contain 0.01 mass parts or more and 10 mass parts or less of the acid/base generator with respect to 100 mass parts of the aliphatic polycarbonate (Invention 8).

In the above invention or inventions (Inventions 1 to 8), the aliphatic polycarbonate may preferably have a structural unit represented by General Formula (1a) below (Invention 9). 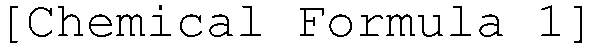 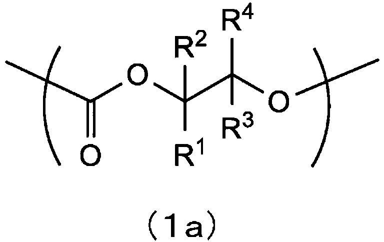 (In the formula, R¹, R², R³, and R⁴ each independently represent a hydrogen atom, a linear hydrocarbon group whose carbon number is 1 to 8, an alicyclic hydrocarbon group whose carbon number is 3 to 8, or an aromatic hydrocarbon group whose carbon number is 6 to 8.)

In the above invention or inventions (Inventions 1 to 9), the aliphatic polycarbonate may preferably have a glass-transition temperature of -40°C or higher and 150°C or lower (Invention 10).

In the above invention or inventions (Inventions 1 to 10), the aliphatic polycarbonate may preferably have a weight-average molecular weight of 2,000 or more and 1,000,000 or less (Invention 11).

In the above invention or inventions (Inventions 1 to 11), the decomposable film may preferably have a thickness of 1 µm or more and 50 µm or less (Invention 12).

Third, the present invention provides a method of producing a resist pattern, comprising: a step of preparing a decomposable film containing an aliphatic polycarbonate and an acid/base generator that generates an acid or base by irradiation with energy rays; an irradiation step of irradiating a part of the decomposable film in a planar view with energy rays; and a decomposition step of heating the decomposable film to decompose the part of the decomposable film in the planar view (Invention 13).

### Advantageous Effect of the Invention

According to the method of using a decomposable film of the present invention, the decomposable film can be easily decomposed. Moreover, according to the method of producing a resist pattern of the present invention, a resist pattern can be easily produced.

### Embodiments for Carrying out the Invention

Hereinafter, one or more embodiments of the present invention will be described.

### <Method of using Decomposable film>

The method of using a decomposable film according to a first embodiment of the present invention includes: a step of preparing a decomposable film containing an aliphatic polycarbonate and an acid/base generator that generates an acid or base by irradiation with energy rays, the decomposable film containing 10 mass% or less of a pressure sensitive adhesive resin other than the aliphatic polycarbonate; an irradiation step of irradiating an entire surface of the above decomposable film or a part of the above decomposable film in a planar view with energy rays; and a decomposition step of heating the above decomposable film to decompose the entire surface of the decomposable film or the part of the decomposable film in the planar view.

The method of using a decomposable film according to a second embodiment of the present invention includes: a step of preparing a decomposable film containing an aliphatic polycarbonate and an acid/base generator that generates an acid or base by irradiation with energy rays; an irradiation step of irradiating an entire surface of the above decomposable film or a part of the above decomposable film in a planar view with energy rays; and a decomposition step of heating the above decomposable film at 30°C or higher and 120°C or lower to decompose the entire surface of the above decomposable film or the part of the decomposable film in the planar view.

In the above methods, when the above decomposable film is irradiated with energy rays, an acid or base is generated by the action of the acid/base generator. The action of this generated acid or base lowers the back-biting initiation temperature of the aliphatic polycarbonate, allowing it to decompose even at a relatively low temperature. By heating the decomposable film in this state, the aliphatic polycarbonate is effectively thermally decomposed, and the decomposable film itself is also decomposed. Thus, according to the above method of using a decomposable film, the decomposable film can be easily decomposed, and if desired, the decomposable film can be decomposed at a relatively low temperature. Moreover, by irradiating the decomposable film with energy rays in a desired pattern, the decomposable film can be decomposed in the desired pattern. In other words, a desired pattern (a pattern that is the inverse of the decomposed pattern) can be easily formed by a dry process that does not require a development step using a liquid.

### 1. Preparation of Decomposable film

The decomposable film used in the present embodiment contains an aliphatic polycarbonate and an acid/base generator that generates an acid or base by irradiation with energy rays. In the decomposable film, the content of pressure sensitive adhesive resins other than the aliphatic polycarbonate may be preferably 10 mass% or less, more preferably 7 mass% or less, particularly preferably 5 mass% or less, further preferably 3 mass% or less, furthermore preferably 1 mass% or less, and most preferably 0 mass%. This allows the amount of residue after the decomposition step to be reduced.

### 1-1. Each Component

### (1) Aliphatic Polycarbonate

### (1-1) Structure of Aliphatic Polycarbonate

The aliphatic polycarbonate used in the decomposable film of the present embodiment may be a polycarbonate whose main chain is composed of a carbonate group (-O-C(=O)-O-) and an aliphatic group, and has a structure in which the divalent aliphatic groups that constitute the main chain are linked by the carbonate group.

The above aliphatic polycarbonate may have a carboxylic ester bond (-C(=O)-O-) in its main chain, but preferably may not have that. When the aliphatic polycarbonate does not have a carboxylic ester bond in its main chain, the above aliphatic polycarbonate does not include a polymer having a polycarbonate skeleton obtained by forming an ester bond in the main chain through reaction of a carboxylic acid or its derivative with an alcohol. Here, examples of derivatives of carboxylic acid include carboxylic acid anhydrides and carboxylic acid halides capable of forming ester bonds.

The above aliphatic polycarbonate may further have a urethane bond (-NH-C(=O)-O-) in its main chain, but preferably may not have that. When the aliphatic polycarbonate does not have a urethane bond in the main chain, the above aliphatic polycarbonate does not include a polymer having a polycarbonate skeleton obtained by forming a urethane bond in the main chain through reaction of a compound having an isocyanate group with an alcohol.

The above aliphatic polycarbonate may further have an ether bond (-O-) in its main chain.

The aliphatic polycarbonate may have either or both of a carboxylic ester bond and a urethane bond in its side chain, or may not have them.

Examples of the above aliphatic polycarbonate include those having a structural unit represented by General Formula (1) below. 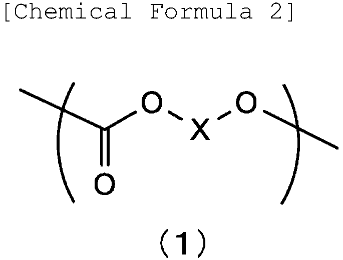 (In the formula, X is a divalent aliphatic hydrocarbon group that is unsubstituted or has a substituent.)

In the formula, X is a divalent aliphatic hydrocarbon group that is unsubstituted or has a substituent, and such an aliphatic hydrocarbon group may be any of a linear one, a branched one, and a cyclic one, and may have both a chain structure and a cyclic structure. Cyclic aliphatic hydrocarbon groups may be monocyclic or polycyclic.

In X, the aliphatic hydrocarbon group that has a "substituent" refers to an aliphatic hydrocarbon group in which one or more hydrogen atoms are substituted with a group (substituent) other than a hydrogen atom.

When the above aliphatic hydrocarbon group has a substituent, the substituent is not particularly limited, but examples thereof include hydroxyl groups, carboxyl groups, halogen atoms, alkoxy groups, alkenyl groups, alkenyloxy groups, aryl groups, heteroaryl groups, aryloxy groups, heteroaryloxy groups, alkylsilyl groups, and alkylsilyloxy groups. Thus, the above aliphatic polycarbonate may or may not have an aromatic group in a side chain branching from the main chain, provided that the groups other than the carbonate groups constituting the main chain are only aliphatic groups.

Examples of halogen atoms in the above substituents include fluorine atoms, chlorine atoms, bromine atoms, and iodine atoms.

Examples of alkoxy groups in the above substituents include the same alkoxy groups as those in R¹, etc., which will be described later, such as methoxy, ethoxy, n-propoxy, isopropoxy, n-butoxy, isobutoxy, sec-butoxy, tert-butoxy, cyclopropoxy, and cyclobutoxy groups.

Examples of alkenyl groups in the above substituents include the same alkenyl groups as those in R¹, etc., which will be described later, such as vinyl, allyl, 1-methylethenyl, 2-methylethenyl, 1-cyclohexenyl, 2-cyclohexenyl, and 3-cyclohexenyl groups.

Examples of alkenyloxy groups in the above substituents include monovalent groups in which oxygen atoms are bonded to the aforementioned alkenyl groups, such as ethenyloxy, 2-propenyloxy, 1-methylethenyloxy, 2-methylethenyloxy, 1-cyclohexenyloxy, 2-cyclohexenyloxy, and 3-cyclohexenyloxy groups.

The aryl groups in the above substituents may be any of monocyclic ones and polycyclic ones, and may preferably those whose carbon number is 6 to 13. Examples thereof include phenyl, 1-naphthyl, 2-naphthyl, o-tolyl, m-tolyl, p-tolyl, and xylyl (dimethylphenyl), as well as those in which one or more hydrogen atoms of aryl groups are further substituted with these aryl groups or the same alkyl groups as those in R¹, etc., which will be described later. The carbon number of these aryl groups having substituents, including those in the substituents, may be preferably 6 to 13.

The heteroaryl groups in the above substituents may be any of monocyclic ones and polycyclic ones. Such heteroaryl groups may be, for example, those having aromaticity in which one or more carbon atoms constituting the aromatic ring skeleton in the aforementioned aryl groups are substituted with heteroatoms, either alone or together with the hydrogen atoms bonded to the carbon atoms, or those having aromaticity in which one or more carbon atoms constituting the ring skeleton in cyclic unsaturated aliphatic hydrocarbon groups whose carbon number is 3 or more are substituted with heteroatoms, either alone or together with the hydrogen atoms bonded to the carbon atoms. Preferred examples of such heteroatoms include oxygen atoms, nitrogen atoms, sulfur atoms, selenium atoms, and phosphorus atoms. The number of heteroatoms constituting the aromatic ring skeleton is not particularly limited, but may be preferably 1 to 2. When the number of heteroatoms constituting the aromatic ring skeleton is 2 or more, these multiple heteroatoms may all be the same, all be different, or only some may be the same.

In the present specification, a group having a structure in which an aromatic hydrocarbon group and an aromatic heterocyclic group are condensed will be referred to, for example, as an aromatic heterocyclic group.

Examples of aryloxy groups in the above substituents include monovalent groups in which oxygen atoms are bonded to the aforementioned aryl groups, such as phenoxy, 1-naphthoxy, and 2-naphthoxy groups.

Examples of heteroaryloxy groups in the above substituents include monovalent groups in which oxygen atoms are bonded to the aforementioned heteroaryl groups.

The alkylsilyl groups in the above substituents may be any of monoalkylsilyl groups, dialkylsilyl groups, and trialkylsilyl groups. In such alkylsilyl groupa, the alkyl groups bonded to the silicon atoms may be any of linear, branched, and cyclic groups, and may have both a linear structure and a cyclic structure. The cyclic alkyl groups may be any of monocyclic and polycyclic groups. Examples of the alkyl groups bonded to the silicon atoms include the same alkyl groups as those in R¹, etc., which will be described later, and the carbon number may be preferably 1 to 10.

In the above dialkylsilyl and trialkylsilyl groups, the two or more alkyl groups may be the same or different. In the trialkylsilyl group, the three alkyl groups may all be the same, all may be different, or only two may be the same.

Examples of alkylsilyloxy groups in the above substituents include monovalent groups in which the aforementioned alkylsilyl groups are bonded to oxygen atoms, such as dimethylsilyloxy, ethylmethylsilyloxy, trimethylsilyloxy, ethylmethyl-n-propylsilyloxy, and ethyldimethylsilyloxy groups.

The number of substituents possessed by the aliphatic hydrocarbon group is not particularly limited, and may be one or more, and all hydrogen atoms may be substituted with substituents. The total number of carbon atoms in the unsubstituted or substituted aliphatic hydrocarbon group, including those in the substituents, may be 1 or more, but may be preferably 2 or more. From another aspect, the total number of carbon atoms including those in the substituents may be preferably 18 or less, more preferably 14 or less, and particularly preferably 12 or less. When the total number of carbon atoms in the aliphatic hydrocarbon group, including those in the substituents, is within the above range, both the film formability and the decomposability can be achieved.

When the number of substituents in the above-described aliphatic hydrocarbon groups is 2 or more, these substituents may be the same or different from each other. That is, the two or more substituents may all be the same, all be different, or only some may be the same. The bonding position of the substituent in the above aliphatic hydrocarbon group is not particularly limited, but may be preferably a position in which the terminal portion of the substituent coincides with the terminal portion of the side chain, and it may be a carbon atom constituting the main chain in X, or a carbon atom at the end of the side chain.

The unsubstituted or substituted aliphatic hydrocarbon group described above may be preferably an unsubstituted or substituted alkylene group, and more preferably an unsubstituted or substituted ethylene group. When the aliphatic hydrocarbon group is such an alkylene group, particularly an ethylene group, the glass-transition temperature (Tg) of the aliphatic polycarbonate may be lowered, and the low-temperature decomposability can be improved.

The above aliphatic polycarbonate may preferably have a structural unit represented by General Formula (1a) below (which may be simply referred to as a "structural unit (1a)," hereinafter).

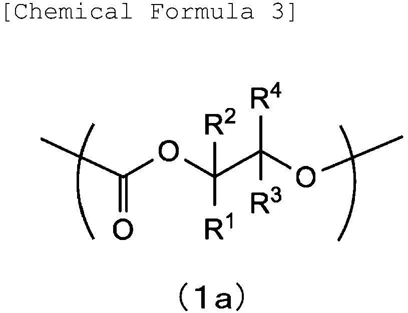

In the formula, R¹, R², R³, and R⁴ are each independently a hydrogen atom, or an unsubstituted or substituted alkyl group or alkoxy group. When any two or more of R¹, R², R³, and R⁴ are unsubstituted or substituted alkyl groups or alkoxy groups, these two or more alkyl groups or alkoxy groups may be bonded to each other to form a ring.

The alkyl groups in R¹ to R⁴ in the formula may be linear, branched, or cyclic, and may have both a chain structure and a cyclic structure, but may be preferably linear. Cyclic alkyl groups may be monocyclic or polycyclic.

Examples of linear or branched alkyl groups include methyl, ethyl, n-propyl, isopropyl, n-butyl, isobutyl, n-pentyl, isopentyl, n-hexyl, 2-methylpentyl, n-heptyl, 2-methylhexyl, 2-ethylhexyl, n-octyl, isooctyl, nonyl, decyl, undecyl, dodecyl, tridecyl, tetradecyl, pentadecyl, and hexadecyl groups.

Examples of cyclic alkyl groups include cyclopropyl, cyclobutyl, cyclopentyl, cyclohexyl, cycloheptyl, cyclooctyl, cyclononyl, cyclodecyl, norbornyl, isobornyl, 1-adamantyl, 2-adamantyl, and tricyclodecyl groups, and further include those in which one or more hydrogen atoms of these cyclic alkyl groups are substituted with linear, branched, or cyclic alkyl groups. Here, examples of the linear, branched, and cyclic alkyl groups substituting hydrogen atoms include those exemplified above as the alkyl groups in R¹ to R⁴.

The carbon number of the linear alkyl group may be preferably 2 or less and more preferably 1. When the carbon number of the alkyl group has such an upper limit, the decomposability can be improved. Moreover, when the carbon number of the alkyl group is within such a numerical range, the above aliphatic polycarbonate having the structural unit (1a) may have a lower glass-transition temperature (Tg) and improved low-temperature decomposability.

The alkoxy groups in R¹ to R⁴ may be any of linear ones, branched ones, and cyclic ones, and may have both a chain structure and a cyclic structure, but may be preferably linear. Cyclic alkoxy groups may be monocyclic or polycyclic.

Examples of linear of branched alkoxy groups include monovalent groups in which oxygen atoms are bonded to the linear or branched alkyl groups in R¹ to R⁴, such as methoxy, ethoxy, n-propoxy, isopropoxy, n-butoxy, isobutoxy, sec-butoxy, n-pentyloxy, isopentyloxy, n-hexyloxy, 2-methylpentyloxy, n-heptyloxy, 2-methylhexyloxy, 2-ethylhexyloxy, n-octyloxy, isooctyloxy, nonyloxy, decyloxy, undecyloxy, dodecyloxy, tridecyloxy, tetradecyloxy, pentadecyloxy, and hexadecyloxy groups.

Examples of cyclic alkoxy groups include monovalent groups in which oxygen atoms are bonded to the cyclic alkyl groups in R¹ to R⁴, such as cyclopropoxy, cyclobutoxy, cyclopentyloxy, and cyclohexyloxy groups.

The carbon number of the linear alkoxy group may be preferably 2 or less and more preferably 1. When the carbon number of the alkoxy group has such an upper limit, the decomposability can be improved. Moreover, when the carbon number of the alkoxy group is within such a numerical range, the above aliphatic polycarbonate having the structural unit (1a) may have a lower glass-transition temperature (Tg) and improved low-temperature decomposability.

When any two or more of R¹ to R⁴ are unsubstituted or substituted alkyl groups or alkoxy groups (referred to as "alkyl groups, etc.," hereinafter), these two or more alkyl groups, etc. may be bonded to each other to form a ring together with the carbon atoms to which these alkyl groups, etc. are bonded. In this case, the position (carbon atom) where these alkyl groups, etc. are bonded to each other is not particularly limited, but when the alkyl groups, etc. having substituents form a ring, it is assumed that carbon atoms at other sites than the substituents are bonded to the carbon atoms of the other alkyl groups. Preferred examples of the position (carbon atom) where two or more alkyl groups, etc. are bonded to each other include terminal carbon atoms (carbon atoms of methyl groups) of these alkyl groups, etc.

When two or more alkyl groups, etc. are bonded to each other to form a ring, the ring may be any of monocyclic one and polycyclic one, and the number of ring members may be preferably 5 to 10.

Preferred examples of the structural unit (1a) in which any two or more alkyl groups, etc. of R¹ to R⁴ form a ring include those in which either R¹ or R² and either R³ or R⁴ are bonded to each other to form a ring.

When the alkyl or alkoxy groups in R¹ to R⁴ have substituents, examples of such substituents include hydroxy groups, carboxy groups, halogen atoms, alkoxy groups, alkenyl groups, alkenyloxy groups, aryl groups, heteroaryl groups, aryloxy groups, heteroaryloxy groups, alkylsilyl groups, and alkylsilyloxy groups, and these substituents are the same as those of the aforementioned aliphatic hydrocarbon groups when they have substituents.

The number of substituents possessed by the alkyl or alkoxy groups in R¹ to R⁴ is not particularly limited, and may be one, two or more, or all hydrogen atoms may be substituted with substituents. The number of carbon atoms in the alkyl or alkoxy groups having substituents, including those in the substituents, may be preferably within the aforementioned range.

When the alkyl or alkoxy groups in R¹ to R⁴ have substituents and the number of the substituents is two or more, these substituents may be the same or different from each other. That is, two or more substituents may all be the same, all be different, or only some may be the same.

The bonding position of the substituents in the alkyl groups or alkoxy groups is not particularly limited, but in the case of an alkyl group, for example, it may be preferably the terminal portion (the carbon atom at the end of the alkyl group opposite the carbon atom bonded to the ethylene group) .

In the case of alkyl groups having substituents, examples of R¹ to R⁴ having substituents include hydroxyalkyl, carboxyalkyl, haloalkyl, alkoxyalkyl, arylalkyl, heteroarylalkyl, aryloxyalkyl, heteroaryloxyalkyl, alkylsilylalkyl, and alkylsilyloxyalkyl groups. When R¹ to R⁴ other than alkyl groups have substituents, example thereof include those in which the hydrogen atoms are similarly substituted with substituents.

From the viewpoint of film formability, the structural unit (1a) may be an unsubstituted or substituted alkyl or alkoxy group (alkyl group, etc.) for any one or more of R¹ to R⁴, but from the viewpoint of decomposability, the number of alkyl groups, etc. in R¹ to R⁴ may be preferably 2 or less, further preferably 1 or less, and particularly preferably 0 (all of R¹ to R⁴ are hydrogen atoms).

In the present embodiment, the structural unit possessed by the aliphatic polycarbonate may be only one type or two or more types, and when there are two or more types, the combination and ratio thereof can be appropriately selected according to the purpose. For example, when the aliphatic polycarbonate has the structural unit (1a), the aliphatic polycarbonate may or may not have a structural unit other than the structural unit (1a). The aliphatic polycarbonate may have only one type of structural unit (1a) or two or more types, and the structural units other than the structural unit (1a) may also be only one type or two or more types.

The aliphatic polycarbonate in the present embodiment may be preferably one in which the ratio of the amount of the structural unit (1a) to the total amount of the structural units is 90 mol% or more, more preferably 95 mol% or more, further preferably 97 mol% or more, particularly preferably 99 mol% or more, and may be 100 mol%.

The aliphatic polycarbonate in the present embodiment may have alkyl groups, etc. in its side chains, but in order to obtain a particularly significant effect of facilitating thermal decomposition, the number of alkyl groups, etc. in the side chains may be preferably 2 or less, particularly preferably 1 or less, and especially preferably 0 (no alkyl groups, etc. in the side chains). Note, however, that either one or both of an alkyl group and an alkoxy group may be present as a side chain from the viewpoint of lowering the glass-transition temperature (Tg) and improving the low-temperature decomposability.

The number of carbon atoms of such alkyl groups and alkoxy groups is as described previously, and may be preferably 2 or less and particularly preferably 1. For example, when the aliphatic polycarbonate of the present embodiment has the structural unit (1a), any one or more of R¹ to R⁴ may be an alkyl group or an alkoxy group, but such alkyl groups or alkoxy groups may be preferably 2 or less among R¹ to R⁴, further preferably 1 or less, and particularly preferably 0 (all of R¹ to R⁴ are hydrogen atoms). When any one or more of R¹ to R⁴ are alkyl groups or alkoxy groups, the alkyl groups or alkoxy groups may be those whose carbon number is 2 or less, and it is more preferred that the alkyl groups or alkoxy groups whose carbon number is 2 or less should be R¹ and/or R² among R¹ to R⁴.

The aliphatic polycarbonate of the present embodiment may be preferably polypropylene carbonate, a polypropylene carbonate derivative, polybutylene carbonate, or a polybutylene carbonate derivative. The decomposable film using such an aliphatic polycarbonate can exhibit excellent decomposability by the method according to the present embodiment.

### (1-2) Physical Properties of Aliphatic Polycarbonate

The aliphatic polycarbonate used in the present embodiment may preferably have a weight-average molecular weight (Mw) of 2,000 or more, more preferably 10,000 or more, particularly preferably 20,000 or more, and further preferably 40,000 or more. This achieves good film formability. From another aspect, the above weight-average molecular weight (Mw) may be preferably 1,000,000 or less, more preferably 700,000 or less, particularly preferably 400,000 or less, and further preferably 200,000 or less. This provides good coatability. In the present specification, unless otherwise specified, the "weight-average molecular weight" refers to a polystyrene-equivalent value measured by a gel permeation chromatography (GPC) method.

The aliphatic polycarbonate used in the present embodiment may preferably have a number-average molecular weight (Mn) of 2,000 or more, more preferably 5,000 or more, particularly preferably 10,000 or more, and further preferably 30,000 or more. This achieves good film formability. From another aspect, the above number-average molecular weight (Mn) may be preferably 500,000 or less, more preferably 400,000 or less, particularly preferably 300,000 or less, and further preferably 150,000 or less. This achieves good coatability. In the present specification, unless otherwise specified, the "number-average molecular weight" refers to a polystyrene-equivalent value measured by a gel permeation chromatography (GPC) method.

The glass-transition temperature (Tg) of the aliphatic polycarbonate used in the present embodiment may be preferably 150°C or lower, more preferably 100°C or lower, particularly preferably 70°C or lower, and further preferably 40°C or lower. This improves the low-temperature decomposability. From another aspect, the above glass-transition temperature (Tg) may be preferably -40°C or higher, more preferably 0°C or higher, particularly preferably 10°C or higher, and further preferably 15°C or higher. This improves the mechanical strength of the film. The specific method of measuring the glass-transition temperature (Tg) in the present specification is as described in the examples, which will be described later.

The content of the aliphatic polycarbonate in the decomposable film in the present embodiment may be preferably 50 mass% or more, more preferably 70 mass% or more, particularly preferably 80 mass% or more, and further preferably 90 mass% or more. This allows the decomposability to be excellent, and can reduce the residues after the decomposition step. On the other hand, the above content may be preferably 99.999 mass% or less, more preferably 99.99 mass% or less, and particularly preferably 99.9 mass% or less. This can ensure the compounding amount of the acid/base generator, which will be described later.

### (1-3) Method of producing Aliphatic Polycarbonate

The aliphatic polycarbonate used in the present embodiment can be produced, for example, by a production method having a step of polymerizing carbon dioxide (CO₂) and a monomer that polymerizes so as to constitute the main chain of an aliphatic group under the presence of a metal catalyst, while controlling the water content to a predetermined amount or less as necessary. For example, an aliphatic polycarbonate having the structural unit (1a) can be produced, as described below, by a production method having a step of polymerizing carbon dioxide and a compound represented by General Formula (1b) below (ethylene oxide (epoxide) or a derivative thereof, which may be simply referred to as a "compound (1b)," hereinafter) under the presence of a metal catalyst, while controlling the water content to a predetermined amount or less as necessary (see, for example, "WO 2011/142259"). In the present specification, unless otherwise specified, the term "monomer" refers to a compound that undergoes a polymerization reaction with carbon dioxide so that the main chain is composed of an aliphatic group. The term "derivative" refers to a compound in which one or more hydrogen atoms of the original compound are substituted with a group (substituent) other than a hydrogen atom, and examples of the "substituent" herein include the same as the substituents when the above-described R¹ to R⁴ have the substituents. 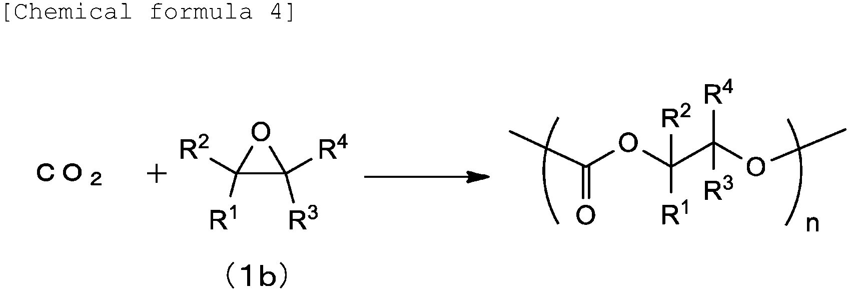 (In the formula, R¹, R², R³, and R⁴ are the same as those described above; n is an integer of 2 or more.)

In the formula, R¹ to R⁴ are the same as R¹ to R⁴ in General Formula (1a) described above. In addition, n is an integer of 2 or more and represents the number of structural units (1a) in the above aliphatic polycarbonate.

Preferred examples of the compound (1b) include ethylene oxide, propylene oxide, 1-butene oxide, 2-butene oxide, isobutylene oxide, 1-pentene oxide, 1-hexene oxide, 1-octene oxide, 1-decene oxide, cyclopentene oxide, styrene oxide, vinylcyclohexene oxide, 3-phenylpropylene oxide, 3,3,3-trifluoropropylene oxide, 3-naphthylpropylene oxide, butadiene monoxide, 3-vinyloxypropylene oxide, 3-trimethylsilyloxypropylene oxide, 3-methoxypropylene oxide (methyl glycidyl ether), 3-n-butoxypropylene oxide (n-butyl glycidyl ether), glycidyl acrylate, and glycidyl methacrylate. Among these, ethylene oxide, derivatives of ethylene oxide, propylene oxide, derivatives of propylene oxide, 1-butene oxide, and derivatives of 1-butene oxide may be more preferred in terms of the high polymerization reactivity of the compound (1b) with carbon dioxide.

The monomers used in the polymerization reaction step (e.g., compound (1b) and monomers other than compound (1b)) may be only one type or two or more types, and when two or more types are used, the combination and ratio thereof may be appropriately adjusted according to the purpose.

Examples of the metal catalyst used in the polymerization reaction step include cobalt catalysts, aluminum catalysts, and zinc catalysts. Among these, the metal catalyst may be preferably a cobalt catalyst and particularly preferably a cobalt salen catalyst because it exhibits high polymerization activity in the polymerization reaction of carbon dioxide with the aforementioned monomers.

The amount of the metal catalyst used during the polymerization reaction may be preferably 0.001 to 20 mass parts and particularly preferably 0.01 to 14 mass parts with respect to 100 mass parts of the monomers used. This allows the polymerization reaction to more readily progress.

In the polymerization reaction step, it is also preferred to use a co-catalyst in addition to the metal catalyst. Examples of the co-catalyst include bis(triphenylphosphoranylidene)ammonium chloride, 4-dimethylaminopyridine, tetrabutylammonium chloride, tetrabutylammonium bromide, triphenylphosphine, 1,5,7-triazabicyclo[4.4.0]dec-5-ene, and 1,4-diazabicyclo[2.2.2]octane.

The amount of the co-catalyst used during the polymerization reaction may be preferably 0.001 to 20 mass parts and particularly preferably 0.01 to 14 mass parts with respect to 100 mass parts of the monomers used. This allows the polymerization reaction to more readily progress.

The method of carrying out the polymerization reaction is not particularly limited, provided that the desired product is obtained. Examples of such a method include a method that includes charging an autoclave with the aforementioned monomers, metal catalyst, and co-catalyst and a solvent as necessary, mixing them, and then injecting carbon dioxide into the obtained mixture to cause reaction.

The solvent used as necessary in the polymerization reaction is not particularly limited, but may be preferably an organic solvent. Examples of organic solvents include aliphatic hydrocarbons such as pentane, hexane, octane, decane, and cyclohexane; aromatic hydrocarbons such as benzene, toluene, and xylene; halogenated hydrocarbons such as chloromethane, dichloromethane, chloroform, carbon tetrachloride, 1,1-dichloroethane, chlorobenzene, and bromobenzene; carboxylic esters such as ethyl acetate, propyl acetate, butyl acetate, and isobutyl acetate; carbonate esters such as dimethyl carbonate, diethyl carbonate, propylene carbonate, and 1,2-butylene carbonate; and lactams such as N-methylpyrrolidone.

The amount of solvent used may be preferably 100 to 10,000 mass parts with respect to 100 mass parts of monomers used from the viewpoint of allowing the polymerization reaction to more readily progress.

The pressure at which carbon dioxide is injected during the polymerization reaction is not particularly limited, but may be preferably 0.1 to 20 MPa, more preferably 0.1 to 10 MPa, and further preferably 0.1 to 5 MPa. By injecting carbon dioxide at a pressure equal to or higher than the above lower limit, the polymerization reaction can more readily progress. Moreover, by injecting carbon dioxide at a pressure equal to or lower than the above upper limit, excessive use of carbon dioxide is suppressed, thus improving economy.

During the polymerization reaction, the amount of water in the reaction system may be preferably set to 5 mol% or less and more preferably 4.5 mol% or less with respect to the amount (mol) of metal catalyst used. The amount of water in the reaction system during the polymerization reaction can be measured, for example, using a Karl Fischer moisture meter. The amount of water in the reaction system can be adjusted, for example, by known methods such as a method using a desiccant.

The reaction temperature during the polymerization reaction is not particularly limited, but may be preferably 20°C or higher and more preferably 40°C or higher. From another aspect, the reaction temperature during the polymerization reaction may be preferably 100°C or lower and more preferably 80°C or lower. By setting the reaction temperature at or above the above lower limit, the polymerization reaction is completed in a shorter time. Moreover, by setting the reaction temperature at or below the above upper limit, side reactions are suppressed, and the yield of the aliphatic polycarbonate is improved.

The reaction time of the polymerization reaction may be adjusted appropriately depending on the reaction temperature, but may be preferably 2 to 40 hours.

After the polymerization reaction is completed, known post-treatment operations can be performed as necessary, and the target aliphatic polycarbonate can be taken out by known methods. The obtained aliphatic polycarbonate may be purified as necessary.

Carbon dioxide is a substance that causes global warming, but on the other hand, it is emitted daily in various industrial fields, and there is a demand for a reduction in emissions on a global scale. In this context, the above-described production method uses carbon dioxide as a raw material, so it can fix carbon dioxide and can be said to be excellent in terms of expanding the options for carbon resources.

The aliphatic polycarbonate contained in the decomposable film in the present embodiment may be only one type or two or more types, and when there are two or more types, the combination and ratio thereof can be selected freely depending on the purpose.

### (2) Acid/Base Generator

The acid/base generator used in the present embodiment generates an acid or base by irradiation with energy rays. Energy rays refer to electromagnetic waves or charged particle rays that have an energy quantum, and specific examples include ultraviolet rays, electron rays, and X-rays. As will be described later, ultraviolet rays, which are easy to handle, may be preferred as the energy rays that irradiate the photodecomposable film according to the present embodiment. That is, the acid/base generator used in the present embodiment may be preferably one that generates an acid or a base by irradiation with ultraviolet rays.

Examples of base generators that generate a base by irradiation with energy rays include α-aminoacetophenone compounds, oxime ester compounds, and compounds having substituents such as an acyloxyimino group, an N-formylated aromatic amino group, an N-acylated aromatic amino group, a nitrobenzyl carbamate group, and an alkoxybenzyl carbamate group. As α-aminoacetophenone compounds, those having two or more nitrogen atoms may be particularly preferred.

Examples of base generators include 9-anthramethyl N,N'-diethylcarbamate, (E)-1-[3-(2-hydroxyphenyl)-2-propenoyl]piperidine, 1,2-diisopropyl-3-[bis(dimethylamino)methylene]guanidium 2-(3-benzoylphenyl)propionate, and 1,2-dicyclohexyl-4,4,5,5-tetramethylbiguanidium n-butyltriphenylborate.

As for base generators, even a small amount of addition can promote the decomposition of the aliphatic polycarbonate, so they may preferably have a biguanide salt structure and a molar absorption coefficient for energy rays with a wavelength of 365 nm of 50 M⁻¹cm⁻¹ or more, more preferably 60 M⁻¹cm⁻¹ or more, and further preferably 70 M⁻¹cm⁻¹ or more. Examples of such base generators include 1,2-diisopropyl-3-[bis(dimethylamino)methylene]guanidium 2-(3-benzoylphenyl)propionate and 1,2-dicyclohexyl-4,4,5,5-tetramethylbiguanidium n-butyltriphenylborate.

One type of the above base generator can be used alone, or two or more types can also be uses in combination.

On the other hand, examples of acid generators that generate acid by irradiation with energy rays include, but are not limited to, naphthoquinone diazide compounds, sulfonium salts, iodonium salts, diazonium salts, selenium salts, pyridinium salts, ferrocenium salts, phosphonium salts, and onium salts such as thiopyrinium salts, and more preferred examples may be aromatic sulfonium salts and aromatic iodonium salts. Examples of anion components include BF₄⁻, PF₆⁻, AsF₆⁻, SbF₆⁻, and B(C₆F₅)₄⁻, with B(C₆F₅)₄⁻, SbF₆⁻, and PF₃(C₂F₅)₃⁻ being particularly preferred.

As for acid generators, even a small amount of addition can promote the decomposition of the aliphatic polycarbonate, so they may preferably have a sulfonium salt structure and a molar absorption coefficient for energy rays with a wavelength of 365 nm of 50 M⁻¹cm⁻¹ or more, more preferably 70 M⁻¹cm⁻¹ or more, further preferably 150 M⁻¹cm⁻¹ or more, and furthermore preferably 300 M⁻¹cm⁻¹ or more. Examples of such acid generators include [1,1'-biphenyl]-4-yl[4-[[1,1'-biphenyl]-4-ylthio]phenyl](phenyl)sulfonium tetrakis(perfluorophenyl)borate, triphenylsulfonium tetrafluoroborate, triphenylsulfonium hexafluoroantimonate, and triphenylsulfonium hexafluoroarsinate.

One type of the above acid generators can be used alone, or two or more types may also be used in combination.

From the viewpoint of preventing corrosion of the adherend, base generators may be more preferred than acid generators.

The content of the acid/base generator in the decomposable film of the present embodiment may be preferably 0.01 mass parts or more, more preferably 0.05 mass parts or more, particularly preferably 0.1 mass parts or more, and further preferably 1 mass part or more with respect to 100 mass parts of the aliphatic polycarbonate. This allows the acid/base generator to exert its action well, and the decomposable film can be decomposed well by the heating step and the decomposition step. From another aspect, the above content may be preferably 10 mass parts or less, more preferably 8 mass parts or less, particularly preferably 6 mass parts or less, and further preferably 5 mass parts or less. This allows the amount of residue left after the decomposition step to be reduced.

### (3) Other Components

In addition to the above components, the decomposable film in the present embodiment may contain various additives, such as sensitizers, plasticizers, crosslinkers, antistatics, thickeners, viscosity reducers, thermal conductive agents, pigments, lightweight fillers, antioxidants, and rust inhibitors, provided that they do not impair the desired decomposability. It is, however, preferred that the decomposable film should not contain any components that become residues after the decomposition step.

### 1-2. Method of Producing Decomposable film

### (1) Preparation of Composition for Forming Decomposable film

To produce the decomposable film in the present embodiment, the aliphatic polycarbonate, the acid/base generator, and optional additives are mixed in a solvent to obtain a coating solution of the composition for forming decomposable film. If any of the above components is in the form of a solid, or if precipitation occurs when the component is mixed with another component in an undiluted state, the component may be preliminarily dissolved in or diluted with a solvent alone and then mixed with the other component.

Examples of the above solvent for use include aliphatic hydrocarbons such as hexane, heptane and cyclohexane, aromatic hydrocarbons such as toluene and xylene, halogenated hydrocarbons such as methylene chloride and ethylene chloride, alcohols such as methanol, ethanol, propanol, butanol and 1-methoxy-2-propanol, ketones such as acetone, methyl ethyl ketone, 2-pentanone, isophorone and cyclohexanone, esters such as ethyl acetate, propyl acetate, butyl acetate and isobutyl acetate, ethers such as diethylene glycol dimethyl ether, cellosolve-based solvents such as ethyl cellosolve, carbonate esters such as propylene carbonate, 1,2-butylene carbonate, dimethyl carbonate and diethyl carbonate, and lactam-based solvents such as N-methylpyrrolidone.

The concentration/viscosity of the coating solution of the composition for forming decomposable film thus prepared is not particularly limited and can be appropriately selected depending on the situation, provided that the concentration/viscosity is within any range in which the coating is possible. For example, the composition for forming decomposable film may be diluted to a concentration of 10 to 60 mass%. When obtaining the coating solution, the addition of a diluent solvent or the like is not a necessary condition, and the diluent solvent may not be added if the composition for forming decomposable film has a viscosity or the like that enables the coating.

### (2) Coating/drying of Composition for forming Decomposable film

A desired object may be coated with the coating solution of the composition for forming decomposable film obtained as above, which may then be dried to obtain the decomposable film.

Drying of the coating film of the composition for forming decomposable film can be performed by a heat treatment. The heating temperature of the heat treatment may be preferably 50°C to 150°C and particularly preferably 70°C to 120°C. The heating time may be preferably 10 seconds to 10 minutes and particularly preferably 50 seconds to 2 minutes.

The object to be coated is not particularly limited, and may be a release sheet, a desired base material, a desired thin film (film to be etched), or the like. For example, the release surface of a release sheet may be coated with the coating solution of the composition for forming decomposable film, which may be dried, and then a desired base material may be laminated thereon to obtain a laminate composed of a release sheet/decomposable film/base material. Alternatively, the release surface of a first release sheet may be coated with the coating solution of the composition for forming decomposable film, which may be dried, and then the release surface of a second release sheet may be laminated thereon to obtain a laminate composed of a first release sheet/decomposable film/second release sheet. On the other hand, when the decomposable film is used for photolithography, for example, a metal thin film formed on a substrate, an oxide film formed on a semiconductor wafer, or the like may be directly coated with the coating solution to form the decomposable film on such a thin film.

Examples of the method of coating with the coating solution of the composition for forming decomposable film include bar coating, knife coating, roll coating, blade coating, die coating, gravure coating, curtain coating, spray coating, and spin coating methods.

### 1-3. Thickness of Decomposable film

The thickness of the decomposable film in the present embodiment may be preferably 1 µm or more, more preferably 3 µm or more, particularly preferably 5 µm or more, and further preferably 10 µm or more. This allows the strength of the film to be maintained at a good level. Moreover, for example, the decomposable film can serve as a resist pattern. On the other hand, the above thickness may be preferably 50 µm or less, more preferably 40 µm or less, particularly preferably 30 µm or less, and further preferably 25 µm or less. This allows the decomposable film to be decomposed well in the decomposition step, which will be described later.

### 2. Irradiation step

In the present embodiment, then the entire surface of the decomposable film or a part of the decomposable film in a planar view is irradiated with energy rays. This irradiation with energy rays may be performed at the same timing as the heating in the decomposition step, which will be described later. That is, the irradiation step and the decomposition step may be performed simultaneously. However, in cases where the acid/base generator is volatilized by heating in the decomposition step, it may be preferred to perform the irradiation step before the decomposition step.

When the decomposable film is irradiated with energy rays, an acid or base is generated from the acid/base generator. The action of the acid or base facilitates thermal decomposition of the aliphatic polycarbonate in the subsequent decomposition step.

As described previously, examples of energy rays include ultraviolet rays, electron rays, and X-rays, among which ultraviolet rays may be preferred because they are easy to handle and irradiation equipment can be easily installed. The wavelength of ultraviolet rays is generally 10 to 400 nm.

The energy rays used for irradiation in the present embodiment may preferably include energy rays (ultraviolet rays) with at least a part of wavelengths of 150 to 400 nm. This allows the acid or base to be more readily generated from the acid/base generator. The above wavelengths may be preferably 190 to 380 nm and particularly preferably 240 to 370 nm.

The light amount (total light amount) of the energy rays (ultraviolet rays) used for irradiation in the present embodiment may be preferably 50 to 1,500 mJ/cm², particularly preferably 80 to 1,200 mJ/cm², and further preferably 100 to 1,100 mJ/cm². This allows the acid or base to be more readily generated from the acid/base generator.

The illuminance of the energy rays (ultraviolet rays) used for irradiation in the present embodiment is usually about 50 to 500 mW/cm², and may be preferably 100 to 450 mW/cm² and more preferably 150 to 300 mW/cm². The source of ultraviolet rays is not particularly limited, and for example, a high-pressure mercury lamp, a metal halide lamp, a UV-LED, or the like can be used.

When electron rays are used as the energy rays, the acceleration voltage may be appropriately selected depending on the type and amount of the acid/base generator and further the thickness of the decomposable film. Usually, the acceleration voltage may be preferably about 10 to 1,000 kV. The irradiation dose may be set within a range in which an acid or base is appropriately generated from the acid/base generator, and may be usually selected within a range of 10 to 1,000 krad. The source of electron rays is not particularly limited, and for example, various electron beam accelerators can be used, such as Cockroft-Walton type, Van de Graff type, resonant transformer type, insulating core transformer type, linear type, dynamitron type, and high frequency type.

In the present embodiment, depending on the use application of the decomposable film, the entire surface of the decomposable film may be irradiated with energy rays, or a part of the decomposable film in a planar view may be irradiated with energy rays. When a part of the decomposable film in a planar view is irradiated with energy rays, the part of the decomposable film to be decomposed is irradiated with energy rays. When it is desired to decompose the decomposable film in a desired pattern, it is preferred to irradiate the decomposable film with energy rays using a mask having a pattern that is the inverse of the desired pattern. This allows the desired part of the decomposable film to be decomposed. A known mask can be used as the mask, and is not particularly limited, provided that it is made of a material that does not transmit energy rays.

As a method of irradiating the part of the decomposable film to be decomposed with energy rays, a UV laser can be used to irradiate the desired part with UV laser light without using a mask.

### 3. Decomposition Step

In the present embodiment, the decomposable film is heated at the end to decompose the entire surface of the decomposable film or a part of the decomposable film in a planar view. In the aforementioned irradiation step, the action of the acid or base generated from the acid/base generator makes the aliphatic polycarbonate susceptible to thermal decomposition. Therefore, the aliphatic polycarbonate is thermally decomposed by the above heating, and the decomposable film is decomposed accordingly. If the decomposable film does not substantially contain any components other than the aliphatic polycarbonate and the acid/base generator, contamination by residues can be suppressed.

The heating temperature may be preferably 30°C or higher, more preferably 40°C or higher, particularly preferably 50°C or higher, and further preferably 55°C or higher. This allows the aliphatic polycarbonate to be thermally decomposed well, and the decomposable film can be decomposed well accordingly. From another aspect, the above heating temperature may be preferably 150°C or lower, more preferably 120°C or lower, particularly preferably 110°C or lower, and further preferably 105°C or lower. As described previously, in the present embodiment, the aliphatic polycarbonate can be decomposed even at a relatively low temperature, so the decomposable film can also be decomposed even at a relatively low temperature as described above.

The heating time may be preferably 1 to 30 minutes, more preferably 2 to 27 minutes, particularly preferably 3 to 25 minutes, and further preferably 4 to 20 minutes. This allows the decomposable film to be decomposed well.

The heating means is not particularly limited, and it may be selected appropriately depending on the use application of the decomposable film. For example, suitable means such as a hot air dryer, a near infrared lamp, or a hot plate can be used.

### 4. Use Application

Methods of using the decomposable film according to the embodiment include, for example, a method of producing a resist pattern, use as a temporary fixing material (agent), use as an easily degradable adhesive, etc.

### <Method of producing Resist Pattern>

The method of producing a resist pattern according to an embodiment of the present invention includes a step of preparing a decomposable film containing an aliphatic polycarbonate and an acid/base generator that generates an acid or base by irradiation with energy rays, an irradiation step of irradiating a part of the decomposable film in a planar view with energy rays, and a decomposition step of heating the decomposable film to decompose the part of the decomposable film in the planar view.

The decomposable film used is as described in the aforementioned embodiment. In the above irradiation step, a mask or the like having a desired pattern can be used to irradiate a part of the decomposable film in a planar view with energy rays. A part of the decomposable film in a planar view can also be irradiated with UV laser light.

Details of the irradiation step and decomposition step are as described in the aforementioned embodiment. According to the method of producing a resist pattern of the present embodiment, a resist film (resist pattern) having a desired pattern can be produced on a metal thin film formed on a substrate or an oxide film formed on a semiconductor wafer, and can be used for photolithography.

It should be appreciated that the aforementioned embodiments are described to facilitate understanding of the present invention and are not described to limit the present invention. It is therefore intended that the elements disclosed in the above embodiments include all design changes and equivalents to fall within the technical scope of the present invention.

In the present specification, unless otherwise specified, the statement of "X to Y" (X and Y are arbitrary numbers) encompasses not only the meaning of "X or more and Y or less" but also the meaning of "preferably more than X" or "preferably less than Y." In addition, unless otherwise specified, the statement of "X or more" (X is an arbitrary number) encompasses the meaning of "preferably more than X," and the statement of "Y or less" (Y is an arbitrary number) encompasses the meaning of "preferably less than Y."

### [Examples]

The present invention will be described in more detail below by exhibiting examples, but the present invention is not limited to the following examples or the like.

### <Production Example 1>

### (Synthesis of polymerization Catalyst)

(R,R)-N,N'-bis(3,5-di-tert-butylsalicylidene)-1,2-diaminocyclohexanecobalt(II) and pentafluorobenzoic acid were weighed out to a molar ratio of 1:1.1 and put into a flask, to which dehydrated toluene was added. The flask was shielded from light with aluminum foil, and the reaction was allowed to progress at room temperature for 20 hours. The chemical reaction formula is as follows. After the reaction was completed, the solvent was removed under reduced pressure, and the reaction product was washed several times with an excess amount of hexane. It was then vacuum dried at room temperature to obtain a cobalt salen complex.

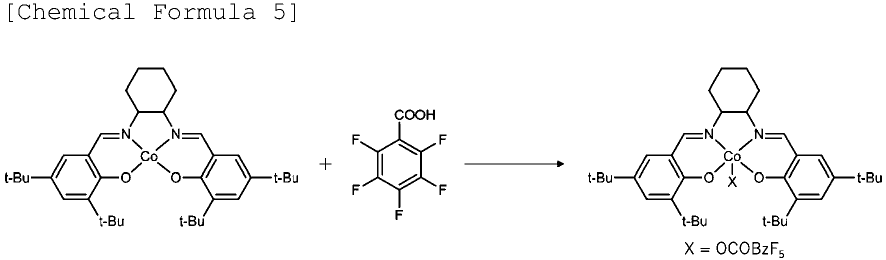

### (Preparation of Aliphatic Polycarbonate (PPC))

A mixed liquid was obtained by dissolving 1,437 mass parts of propylene oxide as a raw material monomer, 10.1 mass parts of the cobalt salen complex obtained above as a catalyst, and 7.1 mass parts of bis(triphenylphosphoranylidene) ammonium chloride as a co-catalyst in 479 mass parts of ethyl acetate.

After preliminarily replacing the atmosphere inside a 4L autoclave system equipped with a stirrer, a gas inlet tube, and a thermometer with a nitrogen atmosphere, the above mixed liquid was charged. Subsequently, carbon dioxide gas was added while stirring the obtained mixture, and the reaction system was filled with carbon dioxide gas until inside of the reaction system reached 3 MPa. After that, the temperature was raised to 40°C, and the polymerization reaction was carried out for 5 hours while replenishing the carbon dioxide consumed by the reaction. After the reaction was completed, the autoclave was cooled and depressurized, the content was diluted with ethyl acetate, and the catalyst was removed by reprecipitation purification.

The obtained ethyl acetate solution was dried, and the generated aliphatic polycarbonate was acquired and analyzed. The glass-transition temperature (Tg) was 30°C, the weight-average molecular weight (Mw) was 43,900, and the number-average molecular weight (Mn) was 35,700. This aliphatic polycarbonate was polypropylene carbonate (PPC).

### <Production Example 2> Preparation of Aliphatic Polycarbonate (PBC)

Aliphatic polycarbonate was prepared in the same manner as in Example 1 except that 1,2-butylene oxide was used instead of propylene oxide as the raw material monomer. The generated aliphatic polycarbonate was acquired and analyzed. The glass-transition temperature (Tg) was 16°C, the weight-average molecular weight (Mw) was 59,000, and the number-average molecular weight (Mn) was 47,000. This aliphatic polycarbonate was polybutylene carbonate (PBC).

Here, the glass-transition temperature (Tg) described in the production examples was obtained by differential scanning calorimetry (DSC) using a product named "DSC Q2000" available from TA Instruments Japan. Specifically, an aluminum pan was used as a container, and the temperature was raised from -70°C to 150°C at 10.0°C/min under a nitrogen atmosphere, held for 5 minutes, then lowered to -70°C at 10.0°C/min, held for 5 minutes, and then raised to 150°C at 10.0°C/min.

The weight-average molecular weight (Mw) and number-average molecular weight (Mn) described in the production examples each refer to a value that is measured as a standard polystyrene equivalent value under the following conditions using a gel permeation chromatographic device (available from Tosoh Corporation, product name "HLC-8320").

### «GPC Measurement Conditions»

- Columns: "TSK guard column Super H-H", "TSK gel Super HM-H," "TSK gel Super HM-H," and "TSK gel Super H2000" (all available from Tosoh Corporation) connected in sequence
- Column temperature: 40°C
- Development solvent: Tetrahydrofuran (copolymer concentration 1 mass%)
- Injection volume: 20 µl
- Flow rate: 0.6 mL/min
- Detector: Differential refractometer
- Standard sample: Polystyrene

### <Example 1>

### 1. Production of Decomposable film

The coating liquid of a composition for forming film was prepared through dissolving 10 mass parts of the polypropylene carbonate obtained in Production Example 1 and 0.5 mass parts of 1,2-diisopropyl-3-[bis(dimethylamino)methylene]guanidium 2-(3-benzoylphenyl)propionate (available from FUJIFILM Wako Pure Chemical Corporation, product name "WPBG-266," molar absorption coefficient for energy rays with a wavelength of 365 nm: 80 M⁻¹cm⁻¹) as a base generator in 40 mass parts of methyl ethyl ketone and thoroughly stirring/mixing them.

The release-treated surface of a tight release sheet (available from LINTEC Corporation, product name "SP-PET382150," thickness: 38 µm) obtained by release-treating one surface of a polyethylene terephthalate film with a silicone-based release agent was coated with the obtained coating liquid of the composition for forming film by using a knife coater, and the coating liquid was then heated and dried at 100°C for 2 minutes to form a film.

Then, the release-treated surface of an easy release sheet (available from LINTEC Corporation, product name "SP-PET381031," thickness: 38 µm) obtained by release-treating one surface of a polyethylene terephthalate film with a silicone-based release agent was laminated on the above film. The thickness of the obtained decomposable film was 20 µm.

### 2. Irradiation Step

The easy release sheet was removed from the above laminate, and the exposed decomposable film was attached to a silicon plate. Subsequently, the tight release sheet was removed from the decomposable film. Then, the decomposable film on the silicon plate was irradiated with ultraviolet rays using a high-pressure mercury lamp at an illuminance: 200 mW/cm² and a light amount: 1,000 mJ/cm². The central wavelength of the ultraviolet rays for irradiation was 365 nm.

### 3. Decomposition Step

Subsequently, the laminate of the decomposable film and silicon plate subjected to irradiation with ultraviolet rays was heated at 60°C for 5, 10, 15, or 20 minutes in a laboratory oven (available from ESPEC CORP., "SPH-202") to decompose the decomposable film.

### <Examples 2 and 3>

The same decomposable films as in Example 1 were decomposed in the same manner as in Example 1 except that the heating temperature in the decomposition step was as listed in Table 1.

### <Example 4>

A decomposable film was produced in the same manner as in Example 1 using the polybutylene carbonate prepared in Production Example 2 instead of the polypropylene carbonate prepared in Production Example 1. Then, after the irradiation step was carried out in the same manner as in Example 1, the decomposition step was carried out in the same manner as in Example 1 except that the heating temperature in the decomposition step was 40°C.

### <Examples 5 to 7>

The same decomposable films as in Example 4 were decomposed in the same manner as in Example 4 except that the heating temperature in the decomposition step was as listed in Table 1.

### <Comparative Examples 1 to 4>

Laminates were each produced in the same manner as in Example 1 using an acrylic-based pressure sensitive adhesive (available from NIPPON CARBIDE INDUSTRIES CO., INC., product name "PE-121") instead of the polypropylene carbonate prepared in Production Example 1. Specifically, laminates each composed of an easy release sheet/pressure sensitive adhesive layer (20 µm)/tight release sheet were produced.

The easy release sheet was removed from each of the above laminates, and the exposed pressure sensitive adhesive layer was attached to a silicon plate. Subsequently, the tight release sheet was removed from the pressure sensitive adhesive layer. Then, the pressure sensitive adhesive layer on the silicon plate was subjected to the irradiation step in the same manner as in Example 1. After that, the decomposition step was carried out in the same manner as in Example 1 at the temperatures listed in Table 1.

### <Testing Example 1>

In the decomposition step of the examples and comparative examples, the decomposable films were heated for 5, 10, 15, and 20 minutes and then allowed to cool, and the thicknesses of the decomposable films and the pressure sensitive adhesive layers were measured. Measurement of thicknesses was carried out in accordance with JIS K7130: 1999 using a constant-pressure thickness meter (available from TECLOCK Co., Ltd., product name "PG-02").

Then, the reduction ratio (film thickness reduction ratio; %) relative to the thickness before the irradiation step was calculated according to the following formula.

Film thickness reduction ratio (%)={ (thickness before irradiation step-measured thickness)/thickness before irradiation step}×100

Subsequently, the decomposability of the decomposable films and pressure sensitive adhesive layers was evaluated based on the following criteria. The results are listed in Table 1.
A... Film thickness reduction ratio was 90% or more.
B... Film thickness reduction ratio was 60% or more and less than 90%.
C... Film thickness reduction ratio was 10% or more and less than 60%.
F... Film thickness reduction ratio was less than 10%.

In each example, the same test as above was also conducted when the irradiation step was not carried out (without UV irradiation). The results are listed in Table 1.

**[Table 1]**

| | Resin | Acid/base generator | Heating temperature [°C] | Evaluation of decomposability | | | | | | | |
|---|---|---|---|---|---|---|---|---|---|---|---|
| | | | | Heating time [minutes] | | | | | | | |
| | | | | 5 | | 10 | | 15 | | 20 | |
| | | | | Without UV irradiation | With UV irradiation | Without UV irradiation | With UV irradiation | Without UV irradiation | With UV irradiation | Without UV irradiation | With UV irradiation |
| Example 1 | Polypropylene **carbonate** | WPBG-266 | 60 | F | C | F | B | F | B | F | A |
| Example 2 | Polypropylene carbonate | WPBG-266 | 80 | F | A | F | A | F | A | F | A |
| Example 3 | Polypropylene carbonate | WPBG-266 | 100 | F | B | F | B | F | B | F | B |
| Example 4 | Polybutylene carbonate | WPBG-266 | 40 | F | C | F | C | F | B | F | A |
| Example 5 | Polybutylene carbonate | WPBG-266 | 60 | F | B | F | B | F | B | F | B |
| Example 6 | Polybutylene carbonate | WPBG-266 | 80 | F | A | F | A | F | A | F | A |
| Example 7 | Polybutylene carbonate | WPBG-266 | 100 | F | B | F | B | F | A | F | A |
| Comparative Example 1 | Acrylic-based pressure sensitive adhesive | WPBG-266 | 40 | F | F | F | F | F | F | F | F |
| Comparative Example 2 | Acrylic-based pressure sensitive adhesive | WPBG-266 | 60 | F | F | F | F | F | F | F | F |
| Comparative Example 3 | Acrylic-based pressure sensitive adhesive | WPBG-266 | 80 | F | F | F | F | F | F | F | F |
| Comparative Example 4 | Acrylic-based pressure sensitive adhesive | WPBG-266 | 100 | F | F | F | F | F | F | F | F |

As found from Table 1, the decomposable films were effectively decomposed by using the decomposable films produced in the examples and carrying out the steps of the examples.

### Industrial Applicability

The method of using a decomposable film according to the present invention is suitable, for example, for the production of a resist pattern.

## Claims

1. A method of using a decomposable film, comprising:
a step of preparing a decomposable film containing an aliphatic polycarbonate and an acid/base generator that generates an acid or base by irradiation with energy rays, the decomposable film containing 10 mass% or less of a pressure sensitive adhesive resin other than the aliphatic polycarbonate;
an irradiation step of irradiating an entire surface of the decomposable film or a part of the decomposable film in a planar view with energy rays; and
a decomposition step of heating the decomposable film to decompose the entire surface of the decomposable film or the part of the decomposable film in the planar view.

2. A method of using a decomposable film, comprising:
a step of preparing a decomposable film containing an aliphatic polycarbonate and an acid/base generator that generates an acid or base by irradiation with energy rays;
an irradiation step of irradiating an entire surface of the decomposable film or a part of the decomposable film in a planar view with energy rays; and
a decomposition step of heating the decomposable film at 30°C or higher and 120°C or lower to decompose the entire surface of the decomposable film or the part of the decomposable film in the planar view.

3. The method of using a decomposable film according to claim 1 or 2, wherein the energy rays used for irradiation in the irradiation step include energy rays with at least a part of wavelengths of 150 to 400 nm.

4. The method of using a decomposable film according to claim 1 or 2, wherein the energy rays used for irradiation in the irradiation step has a light amount of 50 mJ/cm² or more and 1,500 mJ/cm² or less.

5. The method of using a decomposable film according to claim 1 or 2, wherein a heating time in the decomposition step is 1 minute or more and 30 minutes or less.

6. The method of using a decomposable film according to claim 1 or 2, wherein
the acid/base generator is an acid generator that generates an acid by irradiation with energy rays, and
the acid generator has a sulfonium salt structure and has a molar absorption coefficient of 50 M⁻¹cm⁻¹ or more for energy rays with a wavelength of 365 nm.

7. The method of using a decomposable film according to claim 1 or 2, wherein
the acid/base generator is a base generator that generates a base by irradiation with energy rays, and
the base generator has a biguanide salt structure and has a molar absorption coefficient of 50 M⁻¹cm⁻¹ or more for energy rays with a wavelength of 365 nm.

8. The method of using a decomposable film according to claim 1 or 2, wherein the decomposable film contains 0.01 mass parts or more and 10 mass parts or less of the acid/base generator with respect to 100 mass parts of the aliphatic polycarbonate.

9. The method of using a decomposable film according to claim 1 or 2, wherein the aliphatic polycarbonate has a structural unit represented by General Formula (1a) below: 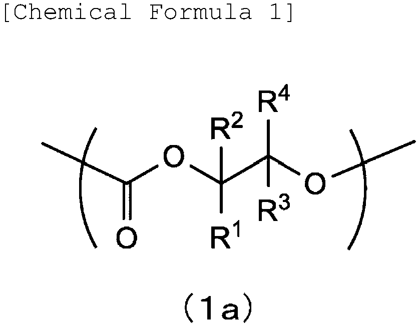 where R¹, R², R³, and R⁴ each independently represent a hydrogen atom, a linear hydrocarbon group whose carbon number is 1 to 8, an alicyclic hydrocarbon group whose carbon number is 3 to 8, or an aromatic hydrocarbon group whose carbon number is 6 to 8.

10. The method of using a decomposable film according to claim 1 or 2, wherein the aliphatic polycarbonate has a glass-transition temperature of -40°C or higher and 150°C or lower.

11. The method of using a decomposable film according to claim 1 or 2, wherein the aliphatic polycarbonate has a weight-average molecular weight of 2,000 or more and 1,000,000 or less.

12. The method of using a decomposable film according to claim 1 or 2, wherein the decomposable film has a thickness of 1 µm or more and 50 µm or less.

13. A method of producing a resist pattern, comprising:
a step of preparing a decomposable film containing an aliphatic polycarbonate and an acid/base generator that generates an acid or base by irradiation with energy rays;
an irradiation step of irradiating a part of the decomposable film in a planar view with energy rays; and
a decomposition step of heating the decomposable film to decompose the part of the decomposable film in the planar view.
